# EUROPÄISCHE PATENTSCHRIFT

(11) **EP 0 442 002 B1**
(45) Veröffentlichungstag und Bekanntmachung des Hinweises auf die Patenterteilung: **12.01.1994**
(21) Anmeldenummer: 90102816.7
(22) Anmeldetag: 13.02.1990
(51) Int. Cl.: H01L 33/00, H01S 3/06

(54) **Strahlungserzeugendes Halbleiterbauelement**
Radiation producing semiconductor device
Dispositif semi-conducteur produisant des radiations

(43) Veröffentlichungstag der Anmeldung: 21.08.1991
(73) Patentinhaber: SIEMENS AKTIENGESELLSCHAFT, 80333 München (DE)
(72) Erfinder: Köck, Anton, Dr., D-8000 München 81 (DE); Gornik, Erich, Prof., D-8000 München 22 (DE)

(56) Entgegenhaltungen:
- EP-A- 0 309 744
- EP-A- 0 334 209
- ARCHIV FUR ELEKTRONIK UND ÜBERTRAGUNGSTECHNIK, vol. 43, no. 6, November 1989, Stuttgart DE, Seiten 388-389 ; ALFRED RAST: "A NOVEL InGaAsP/InP DISTRIBUTED FEEDBACK LASER WITH A CONTACTED SURFACE GRATING FOR LAMBDA=1.55 MICROMETERS"
- PATENT ABSTRACTS OF JAPAN vol. 9, no. 102 (E-312)(1825) 4. Mai 1985 ; & JP-A-59 229891 (FUJITSU K.K.) 24. Dezember 1984
- PATENT ABSTRACTS OF JAPAN vol. 8, no. 139 (E-253)(1576) 28. Juni 1984 ; & JP-A-59 48975 (NIPPON DENKI K.K.) 21. März 1984
- JOURNAL OF APPLIED PHYSICS, vol. 66, no. 4, 15. August 1989, New York US, Seiten 1544-1548; M. KUIJK et al. : "OPTICAL PLASMA RESONANCE IN SEMICONDUCTORS : NOVEL CONCEPTS FOR MODULATING FAR INFRARED LIGHT"

## Beschreibung

Die Erfindung betrifft ein strahlungserzeugendes Halbleiterbauelement nach dem Oberbegriff des Patentanspruchs 1.

LEDs und Laserdioden stellen beispielsweise für die Kommunikation über optische Glasfaserkabel die interessantesten Lichtquellen dar. Die Vorteile, die Laserdioden im Vergleich zu LEDs aufweisen, sind eine wesentlich höhere externe Quantenausbeute (d. h. Zahl der emittierten Photonen pro Elektron) und damit höhere Leistung, eine deutlich kleinere Linienbreite und eine definierte Polarisation des emittierten Lichtes.

Im Hinblick auf verschiedene technische Anwendungen weisen LEDs allerdings eine Reihe von wesentlichen Vorteilen gegenüber Laserdioden auf. Die emittierte Leistung ist bei LEDs weniger temperaturabhängig, so daß LEDs im praktischen Einsatz deutlich stabiler sind als Laserdioden. LEDs können bei viel höheren Temperaturen betrieben werden und benötigen keinen aufwendigen Regelkreis. Zudem sind LEDs viel einfacher herzustellen und besitzen eine höhere Lebenserwartung.

Zur Zeit werden von verschiedenen Herstellern LEDs im Materialsystem AlGaAs/GaAs angeboten, die ausschließlich bei Verwendung einer Linse (teilweise werden die LEDs in Kunststofflinsen eingegossen) eine mehr oder weniger gerichtete Abstrahlung aufweisen. Derzeit liegen bei handelsüblichen LEDs mit Linse die Quantenausbeute in der Größe von 1 bis 2% und die Strahldivergenz (d. h. der volle Winkel des halben Strahlungsmaximums, engl. full angle at half maximum) bei etwa 10° bis 15° bei einem Linsendurchmesser von 4,7 mm und bei 20° bis 60° bei Verwendung von kleineren Linsendurchmessern.

Aufgabe der vorliegenden Erfindung ist es, ein einfach herzustellendes strahlungsemittierendes Halbleiterbauelement anzugeben, das bei hoher Quantenausbeute eine geringe Strahldivergenz aufweist.

Diese Aufgabe wird mit dem Halbleiterbauelement mit den Merkmalen des Anspruches 1 gelöst. Weitere Ausgestaltungen ergeben sich aus den Unteransprüchen.

Es erfolgt eine Beschreibung von erfindungsgemäß aufgebauten Halbleiterbauelementen, insbesondere Leuchtdioden, anhand der Figuren 1 bis 8, in denen jeweils eine Ausführungsform dieses erfindungsgemäßen Bauelementes in Schnittaufsicht dargestellt ist. Die Figuren 9 bis 11 zeigen jeweils ein erfindungsgemäßes Bauelement in Aufsicht mit jeweils unterschiedlicher Anordnung der Emissionsbereiche. Fig. 12 zeigt ein Diagramm mit typischen Richtcharakteristiken.

Der erfindungsgemäße Aufbau basiert auf einem neu entdeckten Emissionsmechanismus über Anregung und Emission von Oberflächenplasmonpolaritonen. Oberflächenplasmonpolaritonen sind transversal elektrische (TE) oder transversal magnetische (TM) Oberflächenmoden, die sich an der Grenzfläche zweier verschiedener Medien ausbreiten können. Bei geeigneter periodischer Strukturierung der Grenzfläche können diese Moden mit elektromagnetischen Wellen angeregt werden. Unter Anwendung dieses Emissionsmechanismus lassen sich die Eigenschaften von lichtemittierenden Dioden (LEDs und Laserdioden) grundlegend und entscheidend verbessern. Bei herkömmlichen LEDs auftretende Verlustmechanismen, die deren Wirkungsgrad limitieren, werden damit umgangen und die Verluste reduziert. Bei gleichzeitig deutlich verringerter Linienbreite wird eine drastische Erhöhung der externen Quantenausbeute und eine gerichtete Abstrahlung definierter Polarisation mit einer Strahldivergenz von weniger als 6° erreicht, wobei auf die Verwendung einer Linse verzichtet werden kann.

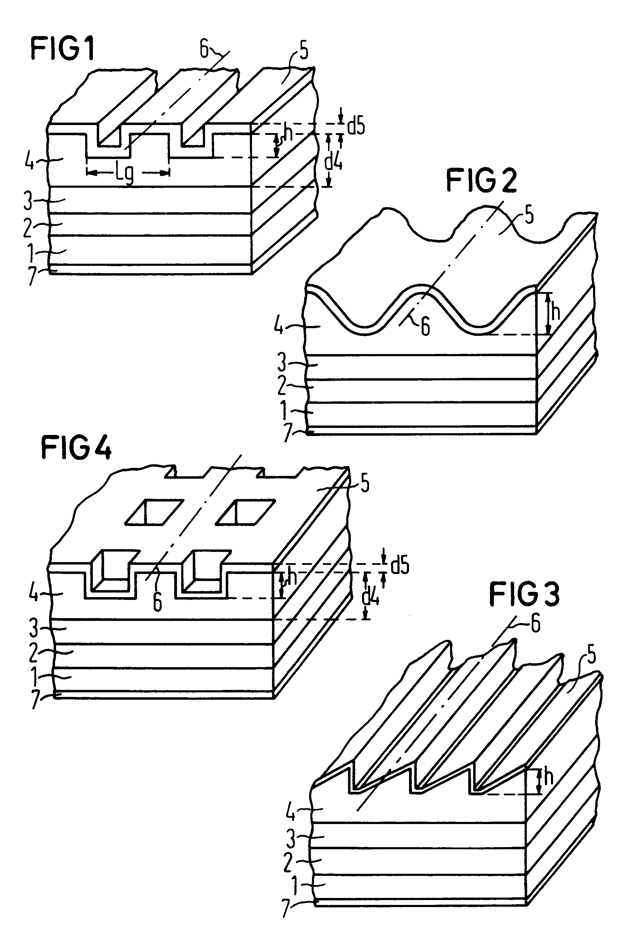

Der Unterschied zu herkömmlichen LEDs liegt bei dem erfindungsgemäßen Aufbau in einer periodischen Strukturierung der Oberfläche des Halbleitermaterials, die mittels üblicher Technologie hergestellt wird. Diese Gitterstruktur kann im Längsschnitt z. B. sinusförmiges, dreieckförmiges oder rechteckförmiges Profil haben, es sind aber auch andere Oberflächenprofile mit Gitterstruktur möglich. Ein auf diese Strukturierung aufgebrachter semitransparenter Metallfilm (erster Kontakt 5 in Fig. 1) ermöglicht die Anregung von Oberflächenplasmonpolaritonen an der Oberfläche dieses Metallfilms.

Der Metallfilm kann gleichzeitig als ohmscher Frontkontakt dienen (wie in Fig. 1 dargestellt); der Metallfilm für die Emission von Oberflächenplasmonpolaritonen kann auch zusätzlich zu der ohmschen Kontaktmetallisierung ausgeführt sein. Die Oberflächenplasmonpolaritonen werden angeregt durch bei Betrieb des Bauelementes in einer aktiven Zone 3 generierte Photonen, deren H-Feldvektor parallel zur der in Fig. 1 eingezeichneten Achse 6 orientiert ist. Die angeregten Oberflächenplasmonpolaritonen emittieren aufgrund ihrer besonderen Eigenschaften Licht definierter Polarisation (p-Polarisation, d. h. H-Feldvektor parallel zu der Achse 6) in eine von der Gitterperiode abhängige Richtung. Diese Abstrahlrichtung kann daher durch Variation der Gitterperiode beliebig eingestellt werden. Für eine vertikale Emission muß die Gitterperiode (Gitterkonstante) etwa gleich sein der zu emittierenden Wellenlänge. Genau muß gelten, daß die Gitterperiode gleich dem Produkt der zu emittierenden Wellenlänge und √1̅+̅1̅/̅ε̅ ( ε = Dielektrizitätskonstante des Metalls) ist, damit diese zu emittierende Wellenlänge vertikal abgestrahlt wird. Der Öffnungswinkel der Strahlung (Strahldivergenz) ist dabei wesentlich kleiner als bei herkömmlichen oberflächenemittierenden LEDs ohne periodische Strukturierung der Oberfläche.

Wird auf den Metallfilm zusätzlich ein Dielektrikum (dessen Dicke typischerweise nicht größer als 5 µm ist) aufgebracht, so ist die Ausbreitung von TEᵢ- und TMᵢ-Moden i-ter Ordnung möglich, wobei die Zahl der Moden und der maximale Index i von der Dicke des Dielektrikums abhängt: Mit zunehmender Dicke nimmt die Zahl der Moden in der Reihenfolge TM_{O}, TE_{O}, TMₗ, TEₗ,... usw. zu, d. h. es breiten sich zusätzlich zur TM_{O}-Mode (bei Fehlen des Dielektrikums) weitere Moden aus. In dieser Notation ist die TM_{O}-Mode identisch mit dem Begriff Oberflächenplasmon. Der Oberbegriff für alle bei Vorhandensein des Dielektrikums auftretenden Moden (TMᵢ, TEᵢ) ist Oberflächenplasmonpolariton.

An der Grenzfläche zwischen dem Metallfilm und der Luft kann sich die TM_{O}-Mode ausbreiten, die durch p-polarisiertes Licht (H-Feldvektor parallel zu Achse 6) angeregt werden kann. Entsprechend kann sich an der Grenzfläche zwischen dem zusätzlich aufgebrachten Dielektrikum und der Luft die TE_{O}-Mode ausbreiten, die durch s-polarisiertes Licht (E-Feldvektor parallel zu Achse 6) angeregt werden kann. Bei besonders vorteilhaften Ausführungsformen des erfindungsgemäßen Bauelements werden vorrangig die TM_{O}-, die TE_{O}- und die TMₗ-Mode von Bedeutung sei.

Bei dem Ausführungsbeispiel nach Fig. 1 sind auf einem n-dotierten Substrat 1 nacheinander übereinander aufgewachsen eine n-dotierte erste Confinementschicht 2, eine p-dotierte aktive Schicht 3 und eine p-dotierte zweite Confinementschicht 4. Das Substrat 1 und die aktive Schicht 3 sind z. B. GaAs, die Confinementschichten 2, 4 Al_{0,3}Ga_{0,7}As. Eingezeichnet sind weiter ein erster Kontakt 5 und ein zweiter Kontakt 7 zum Anlegen des Betriebsstromes. Die Vorzeichen der Dotierung können auch umgekehrt sein, und es kommen andere für Leuchtdioden oder Laserdioden gebräuchliche Materialsysteme in Frage. Wesentlich für den erfindungsgemäßen Aufbau ist eine gitterförmige Strukturierung der Oberfläche der zweiten Confinementschicht 4, die ihrerseits aus verschiedenen Schichtkomponenten zusammengesetzt sein kann. Diese periodische Strukturierung der Oberfläche, ohne die die Anregung und Emission von Oberflächenplasmonpolaritonen nicht möglich ist, überträgt sich auf den dünnen schichtartig aufgebrachten ersten Kontakt 5 aus Metall. Auf dessen Oberfläche, d. h. Grenzfläche zur Luft werden die Oberflächenplasmonen angeregt, die in einen durch die Energie- und Impulsgleichungen bestimmten Winkel, der von der Gitterperiode abhängt, abgestrahlt werden. Statt des rechteckigen Längsschnittprofils der einzelnen Gitterstege wie in Fig. 1 kommt auch ein gewelltes, z. B. sinusförmiges Gitterprofil entsprechend Fig. 2 oder ein symmetrisches oder asymmetrisches dreieckiges Gitterprofil wie in Fig. 3 in Frage. Wesentlich ist die periodische Strukturierung.

Für die Effektivität der Anregung und Emission von Oberflächenplasmonen sind die Dicke d4 der zweiten Confinementschicht 4, die Gitterperiode Lg (Gitterkonstante), die Gitterhöhe h, d. h. die Höhe der aufgebrachten Oberflächenstrukturierung (Amplitude der Schichtdickendifferenz) dieser zweiten Confinementschicht 4 und das Verhältnis von Gitterperiode Lg zu Gitterhöhe h von entscheidender Bedeutung. Der Abstand der aktiven Schicht 3 von der Metalloberfläche (d. h. der Grenzfläche Metall/Luft) des ersten Kontaktes 5 (d4 + d5, wobei d5 die Dicke des ersten Kontaktes 5 ist) ist für den Kopplungsgrad zwischen den in dieser aktiven Schicht 3 erzeugten Photonen und den auf der Metalloberfläche angeregten Oberflächenplasmonen wesentlich. Durch eine Verringerung des Abstandes (d4 + d5) der aktiven Schicht 3 von der Metalloberfläche läßt sich daher der Wirkungsgrad der Leuchtdiode steigern. Vorteilhafte Abmessungen sind: Dicke d4 der zweiten Confinementschicht 4 maximal 3 µm, Gitterhöhe h maximal 1 µm, Dicke d5 des ersten Kontaktes 5 maximal 2 µm.

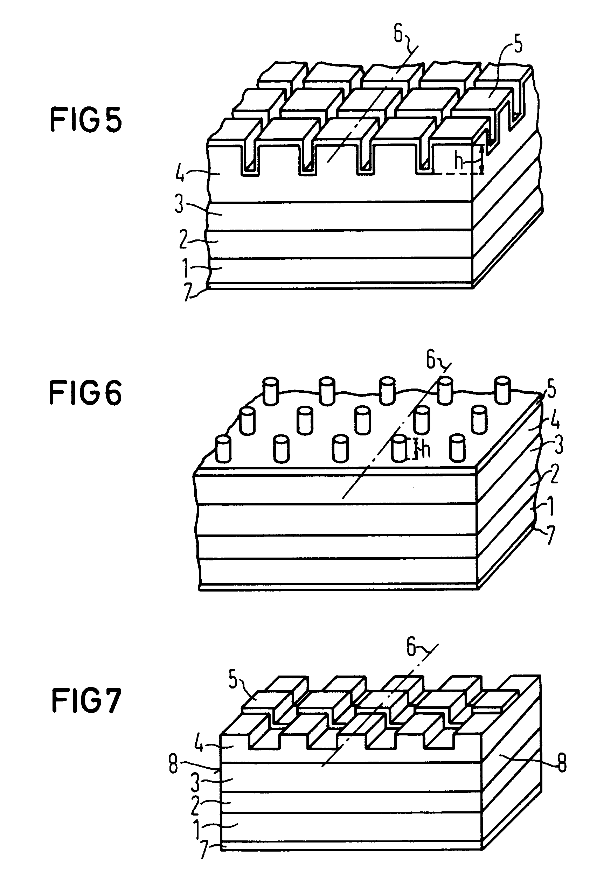

Fig. 4 zeigt ein Ausführungsbeispiel, bei dem die Oberfläche der zweiten Confinementschicht 4 mit einem Kreuzgitter strukturiert ist. Die Abstrahlung erfolgt dann mit zwei senkrecht aufeinanderstehenden Polarisationsrichtungen. Dadurch läßt sich die Quantenausbeute weiter erhöhen. Fig. 5 zeigt ein Ausführungsbeispiel mit einem zu dem in Fig. 4 gezeigten Kreuzgitter reziproken Gitter. Fig. 6 hat eine durch Zylinder, die periodisch angeordnet sind, (sogenannte Quantum-Dots) strukturierte Oberfläche. Wesentlich ist, daß die Oberfläche der zweiten Confinementschicht 4 in zwei senkrecht aufeinanderstehenden Richtungen periodisch strukturiert ist. Die Bezeichnung Gitter ist in einem allgemeinen Sinn aufzufassen. Ebenso wie die in den Figuren dargestellten Gitterstrukturen mit Rechteckprofil kommen Kreuzgitter mit sinusförmigen oder dreieckigen Quer- bzw. Längsschnitten in Frage.

Fig. 7 zeigt eine Anwendung auf eine Laserdiode. Bei diesem Aufbau ist ein streifenförmiger erster Kontakt 5 auf eine Gitterstruktur der Oberfläche der zweiten Confinementschicht 4 aufgebracht. Dieser streifenförmige erste Kontakt 5 bewirkt eine laterale Begrenzung (Gewinnführung) der in der aktiven Schicht 3 generierten Strahlung, die zwischen den Resonatorendflächen 8 reflektiert wird. Die zwischen diesen Resonatorendflächen 8, die zusätzlich verspiegelt sein können, reflektierten Photonen regen Oberflächenplasmonpolaritonen an der freien, d. h. an die Luft grenzenden Oberseite des ersten Kontaktes 5 an. Diese Oberflächenplasmonpolaritonen zerfallen unter Aussendung von Strahlung, die wegen der schmalen Linienbreite der Laserstrahlung extrem gerichtet emittiert wird. Der Auskopplungsgrad wird dabei durch den Abstand der aktiven Schicht 3 von der mit dem Metallstreifen versehenen Oberfläche der zweiten Confinementschicht 4 bestimmt und kann je nach Abstand (ca. 0,1 bis 2 µm) beliebig variiert sein.

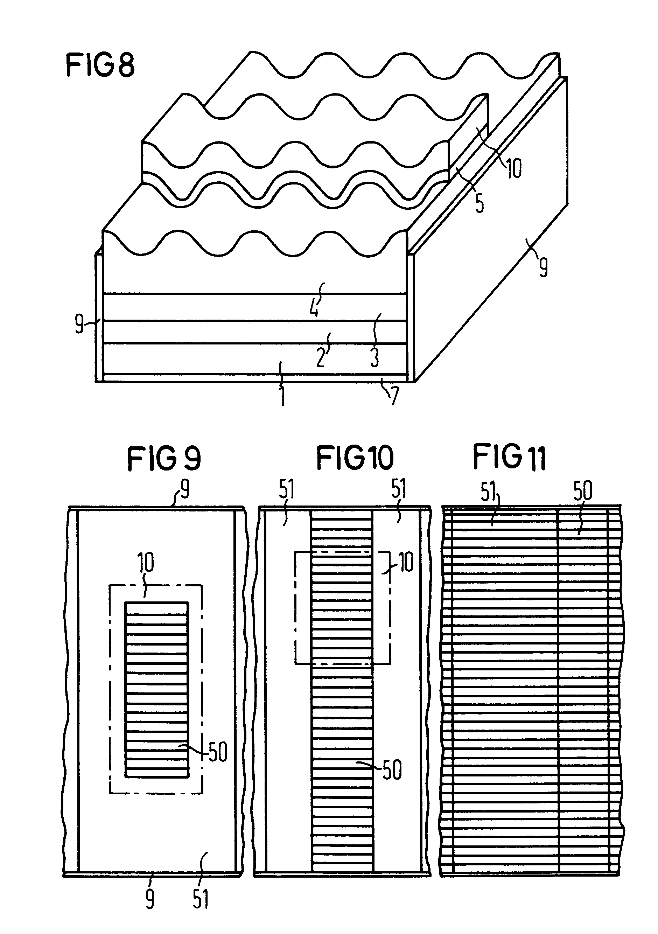

Bei einer Laserdiode, die entsprechend vorliegender Erfindung aufgebaut ist, kommt auch jede der vorstehend erwähnten Gitterstrukturen in Frage. In Fig. 8 ist eine entsprechende Laserdiode mit etwa sinusförmigem Gitterprofil dargestellt. Der den ersten Kontakt 5 bildende Metallstreifen ist mit einer Dielektrikumschicht 10 zur Anregung von TE-Moden versehen. Die Resonatorendflächen sind mit Spiegeln 9 versehen. Auch bei einer Laserdiode kommen verschiedene Gitterprofile in Frage, wobei jeweils eine periodische Strukturierung in Längsrichtung des Lasers wesentlich ist. Das Ausführungsbeispiel entsprechend Fig. 7 bzw. Fig. 8 läßt sich auf eine Anordnung mehrerer miteinander verkoppelter Laser (Laserdiodenarray) erweitern.

Strahlung kann von denjenigen Bereichen der Oberfläche des Halbleitermaterials emittiert werden, in denen eine periodische Strukturierung dieser Oberfläche mit einem semitransparenten Metallfilm versehen ist. In den beschriebenen Ausführungsbeispielen diente jeweils der erste Kontakt 5 gleichzeitig als ohmscher Kontakt für den Anschluß des Betriebsstromes und als dieser semitransparente Metallfilm zur Erzeugung von Oberflächenplasmonpolaritonen. Statt dieser einfachen Ausführungsformen ist es ebenso möglich, den Metallkontakt stellenweise als semitransparenten Metallfilm und im übrigen als entsprechend dicker aufgebrachten ohmschen Kontakt auszubilden. Eine Abstrahlung erfolgt dann in dem Bereich, in dem der semitransparente Metallfilm auf der periodischen Strukturierung (gitterartige Strukturierung) der zweiten Confinementschicht 4 aufgebracht ist. Diese periodische Strukturierung ihrerseits braucht nicht die gesamte freie Oberfläche der zweiten Confinementschicht 4 zu bedecken. Es ist daher möglich, durch eine Begrenzung dieser periodischen Strukturierung den Bereich der Strahlungsemission zu begrenzen. Eine möglicherweise zusätzlich aufgebrachte Dielektrikumschicht 10 braucht ebenfalls nicht den gesamten Metallfilm oder den gesamten mit diesem Metallfilm bedeckten strukturierten Bereich zu bedecken, sondern kann auf Teilbereiche dieses Bereiches begrenzt sein.

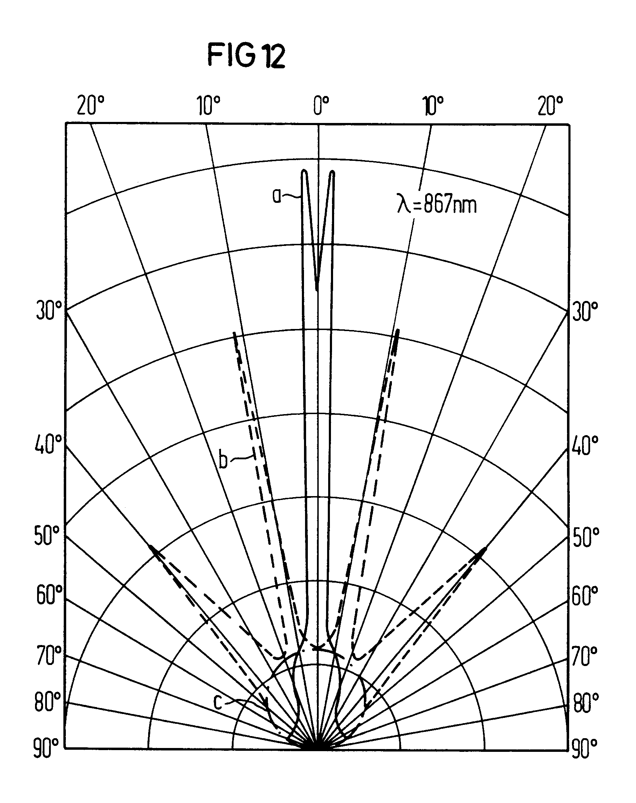

In Fig. 9 bis 11 sind die für die Abstrahlung vorgesehenen Oberseiten dreier Ausführungsbeispiele in Aufsicht dargestellt. Es handelt sich jeweils um Laserdioden mit Spiegeln 9, deren Oberseite eine in den Figuren durch eine sprossenartige Schraffur dargestellte periodische Strukturierung aufweist. Auf diese Oberseite ist jeweils eine Metallschicht aufgebracht, die einen semitransparenten Metallfilm 50 auf dieser gitterartigen Struktur und einen gegebenenfalls dicker aufgebrachten ohmschen Kontakt 51 umfaßt. Der Bereich, in dem eine Dielektrikumschicht 10 zusätzlich auf die Oberseite des Metallfilms aufgebracht ist, ist mit einer strichpunktierten Umgrenzung eingezeichnet. In Fig. 9 ist der Bereich der Strahlungsemission auf ein in der Mitte des Bauelementes befindliches Fenster begrenzt. Dieser Bereich ist außerdem vollständig mit der Dielektrikumschicht 10 bedeckt. In Fig. 10 erfolgt die Strahlungsemission über die gesamte Laserlänge, während die Dielektrikumschicht 10 nur in einem Teilbereich aufgebracht ist. In Fig. 11 ist die periodische Strukturierung ganzflächig aufgebracht, der semitransparente Metallfilm 50 befindet sich aber nur in einem streifenförmigen Bereich, während der ohmsche Kontakt 51 einen daran angrenzenden Teilbereich der Oberfläche bedeckt. Auch in dem Ausführungsbeispiel nach Fig. 11 kann eine Dielektrikumschicht in einem frei wählbaren Bereich aufgebracht werden. Auf diese Weise ergibt sich ein weiter Spielraum für die Anordnung der für Strahlungsemission und der für elektrische Kontaktierung vorgesehenen Bereiche.

Für den semitransparenten Metallfilm eignen sich besonders die Metalle Gold, Silber und Aluminium; es ist aber grundsätzlich jedes Metall verwendbar. Die einschränkende Bedingung, daß die Frequenz des Elektronenplasmas des Metalles größer als die Frequenz der zu emittierenden Strahlung sein muß, ist in allen praktischen Fällen für beliebige Metalle erfüllt.

Fig. 12 zeigt ein Diagramm mit dem Fernfeldmuster bei einer Wellenlänge von 867 nm. Eine ohne Strukturierung der Oberfläche hergestellte LED hat ohne Verwendung einer Linse das Fernfeldmuster entsprechend Kurve c in Fig. 12. Die Emission erfolgt praktisch ungerichtet und völlig unpolarisiert. Bei einer strukturierten LED entsprechend vorliegender Erfindung wird über Anregung und Emission von Oberflächenplasmonen der Anteil mit H-Feldvektor längs der Achse 6 stark verstärkt ausgekoppelt und extrem gerichtet abgestrahlt. Das resultierende Fernfeldmuster bei einer mit der Gitterkonstanten 850 nm modulierten LED ist als Kurve a in Fig. 12 dargestellt. Die Emission erfolgt ohne Verwendung einer Linse mit einer Strahldivergenz von weniger als 6° in einen Winkel von +/-1,3°. Das Fernfeldmuster der senkrecht dazu liegenden Polarisationskomponente ist gleich dem einer unstrukturierten LED und wird somit durch Kurve c dargestellt. Obwohl nur das Licht der einen Polarisationskomponente verstärkt ausgekoppelt wird, ist die insgesamte externe Quantenausbeute im Vergleich zur herkömmlichen, unstrukturierten LED um 51 % auf 1,51 % bei diesem Ausführungsbeispiel gestiegen, während gleichzeitig die Linienbreite im Emissionsmaximum (+/- 1,3° von der Hauptachse) um 26 % auf 27,5 nm gesunken ist. Das Fernfeldmuster einer mit der Gitterperiode 1024 nm modulierten LED ist durch Kurve b dargestellt und demonstriert die über die Periode des Oberflächengitters beinahe beliebig einstellbare Abstrahlcharakteristik.

Vorteile der erfindungsgemäßen LED sind insbesondere eine Verbesserung des Wirkungsgrades und der Abstrahlcharakteristik. Oberflächenstrukturierte LEDs entsprechend vorliegender Erfindung strahlen ohne Verwendung aktiver optischer Komponenten extrem gerichtet ab. Die bisher damit erzielte Strahldivergenz liegt weit unter der herkömmlicher LEDs, die obendrein voluminöse Linsen benötigen, um gerichtet zu emittieren.

Die Quantenausbeute von LEDs mit Oberflächenstrukturierung wird drastisch erhöht, da die einer herkömmlichen LED eigenen und normalerweise nicht vermeidbaren Fresnel- und Reflexionsverluste verringert werden. Einerseits können nämlich auch Photonen, deren Emissionswinkel größer als etwa 16° ist und die normalerweise in das Substrat totalreflektiert werden, Oberflächenplasmonen anregen und über diese Oberflächen-plasmonen als Strahlung ausgekoppelt werden. Andererseits sinkt der Anteil der an der LED/Luft-Grenzfläche zurückreflektierten Photonen stark ab, da in Oberflächenplasmonenresonanz die Reflexion minimal wird. Photonen, die Oberflächenplasmonen anregen, können somit im Idealfall nahezu verlustfrei aus dem Substrat ausgekoppelt werden.

Aufgrund der schmalen Anregungslinie von Oberflächenplasmonpolaritonen sinkt im Maximum der emittierten Intensität die Linienbreite deutlich ab.

Der erfindungsgemäße Aufbau ist nicht auf das Materialsystem AlGaAs/GaAs beschränkt. Er kann ganz allgemein auf Leuchtdioden und Laserdioden beliebiger Emissionswellenlängen und Materialzusammensetzung angewendet werden. Da die Dämpfung der Oberflächenplasmonpolaritonen mit zunehmender Wellenlänge abnimmt, ist der Anregungs- und Emissionsmechanismus der Oberflächenplasmonpolaritonen speziell im Infraroten besonders effektiv. Es muß lediglich die Gitterperiode (Gitterkonstante) der Wellenlänge angepaßt werden.

Da die Anregungseffizienz von Oberflächenplasmonpolaritonen durch in der aktiven Schicht generierte Photonen in erster Linie durch den Abstand dieser aktiven Schicht von der periodisch strukturierten Oberfläche bestimmt wird, ist die Effizienz des Emissionsmechanismus weitgehend unabhängig vom Typus der LED bzw. Laserdiode. Daher kann das Emissionsverfahren durch Oberflächenplasmonpolaritonen ganz allgemein Anwendung finden bei Aufbauten mit Homo-, Hetero- oder Doppelheteroübergängen.

## Patentansprüche

1. Strahlungserzeugendes Halbleiterbauelement
- mit einer aktiven Schicht (3) zwischen einer ersten Confinementschicht (2) und einer zweiten Confinementschicht (4) und
- mit mindestens einem ersten Kontakt (5) und einem zweiten Kontakt (7) zum Anlegen eines Betriebsstromes,
**dadurch gekennzeichnet,**
- daß die von der aktiven Schicht (3) abgewandte Oberfläche der zweiten Confinementschicht (4) mit einer räumlichen periodischen Strukturierung versehen ist,
- daß zumindest auf den mit dieser Strukturierung versehenen Bereich der Oberfläche der zweiten Confinementschicht (4) ein semitransparenter Metallfilm aufgebracht ist und
- daß die Höhe (h) dieser Strukturierung und die Länge (Lg) jeweils einer Periode dieser Strukturierung, die Dicke (d4) der zweiten Confinementschicht (4) und die Dicke (d5) des Metallfilms so bemessen sind, daß im Betrieb des Halbleiterbauelementes an der der zweiten Confinementschicht (4) abgewandten Oberfläche des Metallfilms Oberflächenplasmonpolaritonen durch in der aktiven Schicht (3) erzeugte Photonen angeregt werden.

2. Halbleiterbauelement nach Anspruch 1,
**dadurch gekennzeichnet,**
daß die räumliche periodische Strukturierung ein Gitter ist.

3. Halbleiterbauelement nach Anspruch 2,
**dadurch gekennzeichnet,**
daß das Gitter ein kantiges Profil hat.

4. Halbleiterbauelement nach Anspruch 2,
**dadurch gekennzeichnet,**
daß das Gitter ein gerundetes Profil hat.

5. Halbleiterbauelement nach einem der Ansprüche 1 bis 4,
**dadurch gekennzeichnet,**
daß die räumliche periodische Strukturierung eine Periodizität in zwei voneinander verschiedenen Richtungen aufweist.

6. Halbleiterbauelement nach Anspruch 5,
**dadurch gekennzeichnet,**
daß die räumliche periodische Strukturierung ein Kreuzgitter ist.

7. Halbleiterbauelement nach einem der Ansprüche 1 bis 6,
**dadurch gekennzeichnet,**
daß der Metallfilm zumindest in Teilbereichen mit einer Dielektrikumschicht (10) versehen ist und daß die Dicke dieser Dielektrikumschicht (10) so bemessen ist, daß im Betrieb des Halbleiterbauelementes Oberflächenplasmonpolaritonen in dieser Dielektrikumschicht (10) angeregt werden.

8. Halbleiterbauelement nach einen der Ansprüche 1 bis 7,
**dadurch gekennzeichnet,**
daß der Metallfilm durch den ersten Kontakt (5) gebildet wird.

9. Halbleiterbauelement nach einem der Ansprüche 1 bis 7,
**dadurch gekennzeichnet,**
daß der Metallfilm durch zumindest einen Anteil des ersten Kontakts (5) gebildet wird.

10. Halbleiterbauelement nach einem der Ansprüche 1 bis 9,
**dadurch gekennzeichnet,**
daß die aktive Schicht (3) als Laserresonator mit Resonatorendflächen (8) ausgebildet ist.

11. Halbleiterbauelement nach Anspruch 10,
**dadurch gekennzeichnet,**
- daß der erste Kontakt (5) als Streifenkontakt für den Laserresonator ausgebildet ist,
- daß zumindest ein Anteil dieses ersten Kontaktes (5) als ein semitransparenter Metallfilm ausgebildet ist und
- daß dieser semitransparente Metallfilm zumindest einen Teil der räumlichen periodischen Strukturierung bedeckt.

## Claims

1. Semiconductor component which produces radiation
- having an active layer (3) between a first confinement layer (2) and a second confinement layer (4) and
- having at least one first contact (5) and one second contact (7) for the application of an operating current,
characterized
- in that the surface of the second confinement layer (4) facing away from the active layer (3) is provided with a spatially periodic structuring,
- in that a semitransparent metal film is deposited at least onto the region of the surface of the second confinement layer (4) which is provided with this structuring, and
- in that the height (h) of this structuring and the length (Lg) of in each case one period of this structuring, the thickness (d4) of the second confinement layer (4) and the thickness (d5) of the metal film are dimensioned such that, when the semiconductor component is in operation, surface plasmon polaritons are excited, by photons which are produced in the active layer (3), on the surface of the metal film facing away from the second confinement layer (4).

2. Semiconductor component according to Claim 1, characterized in that the spatial periodic structuring is a lattice.

3. Semiconductor component according to Claim 2, characterized in that the lattice has a polygonal profile.

4. Semiconductor component according to Claim 2, characterized in that the lattice has a rounded profile.

5. Semiconductor component according to one of Claims 1 to 4, characterized in that the spatial periodic structuring has a periodicity in two mutually different directions.

6. Semiconductor component according to Claim 5, characterized in that the spatial periodic structuring is a cross-lattice.

7. Semiconductor component according to one of Claims 1 to 6, characterized in that the metal film is provided at least in partial regions with a dielectric layer (10), and in that the thickness of this dielectric layer (10) is dimensioned such that, when the semiconductor component is in operation, surface plasmon polaritons are excited in this dielectric layer (10).

8. Semiconductor component according to one of Claims 1 to 7, characterized in that the metal film is formed by the first contact (5).

9. Semiconductor component according to one of Claims 1 to 7, characterized in that the metal film is formed by at least a portion of the first contact (5).

10. Semiconductor component according to one of Claims 1 to 9, characterized in that the active layer (3) is constructed as laser resonator having resonator end surfaces (8).

11. Semiconductor component according to Claim 10, characterized
- in that the first contact (5) is constructed as a strip contact for the laser resonator,
- in that at least a portion of this first contact (5) is constructed as a semitransparent metal film, and
- in that this semitransparent metal film covers at least a part of the spatial periodic structuring.

## Revendications

1. Composant à semiconducteurs produisant un rayonnement et comportant
- une couche active (3) située entre une première couche de confinement (2) et une seconde couche de confinement (4), et
- au moins un premier contact (5) et un second contact (7) pour appliquer un courant de fonctionnement,
caractérisé par le fait
- que la surface, tournée à l'opposé de la couche active (3), de la seconde couche de confinement (4) est pourvue d'une structure spatiale périodique,
- qu'une pellicule métallique semi-transparente est disposée au moins sur la zone, pourvue de cette structure, de la surface de la seconde couche de confinement (4), et
- que la hauteur (h) de cette structure et la longueur (Lg) respectivement d'une période de cette structure, l'épaisseur (d4) de la seconde couche de confinement (4) et l'épaisseur (d5) de la pellicule métallique sont telles que, pendant le fonctionnement du composant à semiconducteurs, des polaritons de plasmons de surface sont excités à la surface de la pellicule métallique tournée à l'opposé de la seconde couche de confinement (4), par des photons produits dans la couche active (3).

2. Composant à semiconducteurs suivant la revendication 1, caractérisé par le fait que la structure spatiale périodique est un réseau.

3. Composant à semiconducteurs suivant la revendication 2, caractérisé par le fait que le réseau a un profil anguleux.

4. Composant à semiconducteurs suivant la revendication 2, caractérisé par le fait que le réseau a un profil arrondi.

5. Composant à semiconducteurs suivant l'une des revendications 1 à 4, caractérisé par le fait que la structure spatiale périodique a une périodicité dans deux directions différentes.

6. Composant à semiconducteurs suivant la revendication 5, caractérisé par le fait que la structure spatiale périodique est un réseau bidimensionnel.

7. Composant à semiconducteurs suivant l'une des revendications 1 à 6, caractérisé par le fait que la pellicule métallique comporte, au moins dans des zones partielles, une couche diélectrique (10), et que l'épaisseur de cette couche diélectrique (10) est telle que, lors du fonctionnement du composant à semiconducteurs, des polaritons de plasmons de surface sont excités dans cette couche diélectrique (10).

8. Composant à semiconducteurs suivant l'une des revendications 1 à 7, caractérisé par le fait que la pellicule métallique est formée par le premier contact (5).

9. Composant à semiconducteurs suivant l'une des revendications 1 à 7, caractérisé par le fait que la pellicule métallique est formée par au moins une partie du premier contact (5).

10. Composant à semiconducteurs suivant l'une des revendications 1 à 9, caractérisé par le fait que la couche active (3) est constituée en résonateur laser comportant des surfaces d'extrémité (8).

11. Composant à semiconducteurs suivant la revendication 10, caractérisé par le fait
- que le premier contact (5) est constitué en contact en forme de bande pour le résonateur laser,
- qu'au moins une partie de ce premier contact (5) est constituée en pellicule métallique semi-transparente, et
- que cette pellicule métallique semi-transparente recouvre au moins une partie de la structure spatiale périodique.
